# EUROPEAN PATENT SPECIFICATION

(11) **EP 3 327 374 B1**
(45) Date of publication and mention of the grant of the patent: **22.02.2023**
(21) Application number: 17203639.4
(22) Date of filing: 24.11.2017
(51) Int. Cl.: F25B 5/04, F25B 49/00

(54) **REFRIGERATION SYSTEM AND COOLING METHOD OF ELECTRONIC CONTROL UNIT THEREOF**
KÜHLSYSTEM UND VERFAHREN ZUR KÜHLUNG EINER ELEKTRONISCHEN STEUEREINHEIT DAFÜR
SYSTÈME DE RÉFRIGÉRATION ET PROCÉDÉ DE REFROIDISSEMENT DE SON UNITÉ DE COMMANDE ÉLECTRONIQUE

(30) Priority: 25.11.2016 CN 201611050248; 06.01.2017 US 201715399946
(43) Date of publication of application: 30.05.2018
(73) Proprietor: Carrier Corporation, Jupiter, FL 33478 (US)
(72) Inventor: STARK, Michael A., Pudong, Shanghai 201206 (CN); WANG, Lei, Pudong, Shanghai 201206 (CN); HUANG, Jianxin, Pudong, Shanghai 201206 (CN); YAN, Chaoqun, Pudong, Shanghai 201206 (CN)
(74) Representative: Dehns

(56) References cited:
- WO-A1-2013/001829
- WO-A1-2016/168569
- JP-A- H08 316 676
- JP-A- 2015 127 622
- US-A- 6 116 040
- US-A1- 2008 310 112
- US-A1- 2013 319 038

## Description

The present disclosure relates to a refrigeration system, and in particular, to cooling arrangement of an electronic control device of a refrigeration system and a cooling method thereof.

A refrigeration system generally requires a special electric control unit, for example, for some large refrigeration systems, the electric control unit may be an inverter starting cabinet. Moreover, electronic devices in the inverter starting cabinet generate more heat, and a greater temperature rise has some influences on the working state thereof. Therefore, it is necessary to cool the electronic devices, to meet performance requirements thereof.

At present, there are already several electronic device cooling modes. For example, a plurality of openings is provided on a housing of an electronic control unit, to cool the electronic device through natural convection or forced convection; for another example, a water-cooled heat exchange device is arranged in the housing, to cool the electronic device by introducing cooling water from an external water source. Therefore, the above electronic device cooling mode may have a problem of relatively low efficiency, or may have a problem that the electronic device in the cabinet fails due to improper dehumidification in a high-temperature and high-humidity environment.

US 2013/319/319038 A1 (see Figure 4) discloses a refrigeration system as defined in the preamble of claim 1.

An aspect of the disclosure is to provide a refrigeration system, which can mitigate a cooling problem inside the entire electronic control unit and reduce the humidity in the housing.

According to an aspect of the present disclosure, a refrigeration system according to claim 1 is provided.

According to another aspect of the present disclosure, a cooling method according to claim 10 is provided.

The refrigeration system according to the present disclosure, by connecting an electronic device cooling unit in parallel to a refrigeration loop, provides a cooling and dehumidification mode for its own electronic control unit, and can effectively cool the entire space in the housing of the electronic control unit and dehumidify the electronic control unit. The structural design not only eliminates a high cost of setting a set of special cooling systems but also avoids the problems that the conventional cooling mode of the electronic device is low in efficiency and that the electronic device in the cabinet fails easily due to improper dehumidification in a high-humidity environment, and thus the structural design achieves very high practical value and versatility. In addition, the cooling method for an electronic control unit of a refrigeration system according to the present disclosure, according to temperature and/or humidity changes in the electronic control unit, provides corresponding start and stop methods for an electromagnetic valve and a fan, which, in conjunction with the refrigeration system of the present disclosure, better achieves the function of regulating the temperature and humidity of the elements and environment in the electronic control unit.

Certain aspects of the present invention will now be described, by way of example only, and with reference to the accompanying drawing in which:

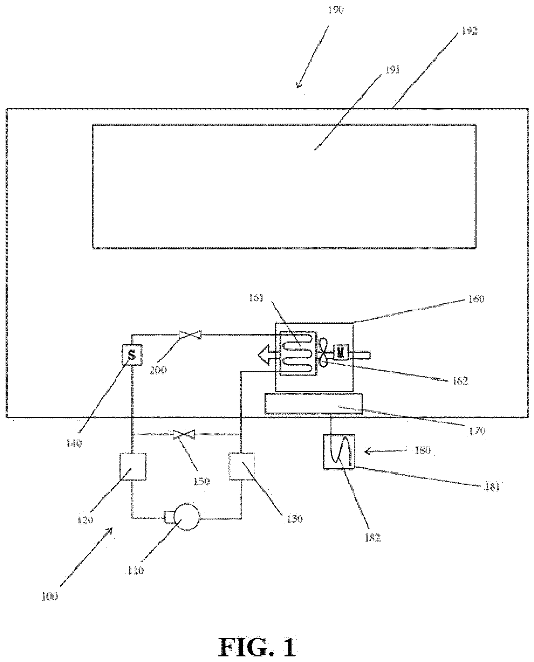

FIG. 1 is a schematic diagram of an embodiment of a refrigeration system according to the present disclosure.

FIG. 1 illustrates an embodiment of a refrigeration system according to the present disclosure. The refrigeration system 100 includes an electronic control unit 190, and the electronic control unit 190 includes a housing 192 and an electronic device 191 arranged in the housing 192, for providing control over various operations of the refrigeration system 100.

The refrigeration system 100 further has a refrigeration loop of conventional components, that is, a compressor 110, a condenser 120, a primary throttling element 150, and an evaporator 130 sequentially connected through a pipeline. The primary throttling element 150 is mainly used for providing a throttling effect on a refrigerant, and may be a capillary tube having a fixed throttling effect or an electronic expansion valve having an adjustable throttling effect, or other units that can be used for throttling. In addition, the refrigeration system 100 further includes an electronic device cooling branch, where the electronic device cooling branch is connected into the refrigeration loop from the condenser 120, and connected back to the refrigeration loop from the evaporator 130, that is, it is connected in parallel to the primary throttling element 150. An electronic device cooling unit 160, a secondary throttling element 200, and an electromagnetic valve 140 are disposed on the electronic device cooling branch. The electronic device cooling unit 160 is used for cooling the electronic device and reducing humidity of an environment where it is located; the secondary throttling element 200 provides a throttling effect on the refrigerant; and the electromagnetic valve 140 can be used for controlling switching on and switching off of the loop and providing a partial throttling effect on the refrigerant. Specifically, the electronic device cooling unit 160 is spaced apart from the electronic device 191 in the housing 192, thereby cooling the air or other components and parts in the electronic device and the housing 192 at the same time.

The electronic device cooling unit 160 includes an air-refrigerant heat exchanger 161 and a fan 162, and forced convective heat transfer between wind and the refrigerant in the heat exchanger 161 is achieved through the fan 162. Various specification parameters of the heat exchanger 161 in the electronic device cooling unit 160 may be designed by using a general heat exchanger design mode, for example, according to the amount of heat generated by the electronic device. Compared with the existing conventional electronic device cooling mode, the structure of the electronic device cooling unit 160 of the present disclosure and the cooling mode adopted by it bring about a better cooling effect than the conventional direct ventilation cooling, bring about better device reliability than the conventional water cooling, and avoid the problem of potential safety hazards of the electronic device caused by water leakage.

As the heat exchange will inevitably produce condensed water in a cooling and dehumidification process, in order to treat the condensed water in a centralized way, a water pan 170 may be arranged below the electronic device cooling unit 160. Certainly, the water pan 170 may also be replaced with a condensed water collecting device in other forms.

In order to optimize structural layout in the electronic control unit 190, various components and parts are reasonably arranged to improve space utilization. The electronic device cooling unit 160 in this embodiment may be arranged at a lower side close to the housing 192 of the electronic control unit 190, and the water pan 170 is arranged close against an inner side below the housing 192 and is just arranged below the heat exchanger 161, to receive condensed water possibly produced on fins of the heat exchanger 161.

As an optional solution, in order to avoid improving the ambient humidity in the housing 192, the condensed water can be guided out of the housing 192 through a condensed water discharging unit 180 and be treated. In an embodiment, the condensed water discharging unit 180 includes: a drain pipe 182 connected at the bottom of the water pan 170, for guiding the condensed water out of the water pan 170; and a water tank 181 arranged outside the housing 192 and used for receiving the condensed water guided out by the drain pipe 182, to facilitate centralized treatment of the condensed water.

The electromagnetic valve 140 and the secondary throttling element 200 are directly arranged in the housing 192, to avoid excessively compact layout of components and parts outside the electronic control unit.

In addition, in order to better control the opportunity of cooling the electronic control unit 190 by the refrigeration system 100 and to handle the control over switching on and switching off of the electromagnetic valve, the present disclosure further includes a temperature sensor and/or a humidity sensor disposed in the electronic control unit 190, thus controlling switching on and switching off of the electromagnetic valve 140 according to a temperature index and/or a humidity index in the electronic control unit 190.

A better effect will be achieved if this set of refrigeration system is applied to a large refrigeration unit (for example, a centrifugal unit or screw unit). This is because during normal operation, a cooling demand of such an electronic control unit 190 to meet the amount of generated heat is usually between 3 kW and 5 kW, which only accounts for a very small portion of the generally hundreds or even thousands of tons of cooling capacity of the large refrigeration unit. Therefore, connecting the electronic device cooling unit 160 in parallel to the large refrigeration unit basically would not affect the work of the original refrigeration system. For example, in this embodiment, the cooling of the electronic control unit 190 is carried out with the cooling capacity carried by only a small portion of the refrigerant in the main refrigeration loop, which not only brings about a better cooling effect than the conventional cooling mode, but also can avoid almost any influence on the work of the main refrigeration loop. This comprehensively achieves improvement of the cooling effect, an increase in the device reliability, a decrease in the system complexity, and so on.

The working process of the present disclosure will be described as follows in combination with the above embodiment. When it is detected that the temperature and/or the humidity index in the housing 192 of the electronic control unit 190 is greater than a certain value, the electromagnetic valve 140 is opened; in this case, the refrigerant, which has been cooled by the condenser 120 and expanded by the electromagnetic valve 140 and the secondary throttling element 200, passes through the air-refrigerant heat exchanger 161, and exchanges heat with an air flow blown by the fan 162. The cooled air flow flows in the whole housing 192, which not only achieves cooling and dehumidification on the electronic device 191, but also achieves regulation and control over the ambient temperature and humidity in the whole housing 192 during the convection, effectively achieving cooling of the electronic device 191 and the environment in the housing 192, and keeping the humidity thereof below a threshold.

The present disclosure further provides an embodiment of a corresponding cooling method for an electronic control unit of a refrigeration system. For example, if the system is controlled according to the temperature, when a main controller in a centrifuge refrigeration system receives an ambient temperature signal in the housing 192 of the electronic control unit 190, the ambient temperature is compared with a built-in preset temperature, and if the ambient temperature is higher than the preset temperature, a control signal is output to open the electromagnetic valve 140 and the fan 162 in the electronic device cooling unit 160. At this point, after passing through the opened electromagnetic valve 140 and being throttled by the secondary throttling element 200, the refrigerant flows to the electronic device cooling unit 160, and exchanges heat with air that flows through the heat exchanger 161 under the driving of the fan, such that the ambient temperature in the whole housing 192 is mitigated and maintained below the preset temperature, thereby avoiding overheating of the electronic control unit.

In addition, if the system is controlled based on both the humidity and the temperature, when the main controller in the centrifuge refrigeration system receives ambient temperature and ambient humidity signals in the housing 192 of the electronic control unit 190, a dew point temperature corresponding to the relative ambient humidity is calculated and compared with the detected ambient temperature: if the calculated dew point temperature is lower than the ambient temperature, a control signal is output to open the electromagnetic valve 140 and the fan 162 in the electronic device cooling unit 160. At this point, after passing through the opened electromagnetic valve 140 and being throttled by the secondary throttling element 200, the refrigerant flows to the electronic device cooling unit 160, and exchanges heat with air that flows through the heat exchanger 161 under the driving of the fan, such that the ambient temperature in the whole housing 192 is improved and maintained above the dew point temperature, thereby avoiding overwetting and condensation of the electronic control unit, and further avoiding the failure thereof; if the calculated dew point temperature is higher than or equal to the detected ambient temperature, an alarm signal or a protection signal is output to remind a user or the electromagnetic valve 140, the fan 162 in the electronic device cooling unit 160, and the compressor main circuit in the refrigeration loop are directly turned off.

Specific implementations of the present disclosure are described in detail as above according to the accompanying drawing. Persons skilled in the art can make equivalent modifications or variations to specific features in the implementations according to the above description. These changed implementations may also fall within the scope of protection covered by the claims.

## Claims

1. A refrigeration system (100), including:
an electronic control unit (190), including a housing (192) and an electronic device (191) arranged in the housing;
a refrigeration loop, including a compressor (110), a condenser (120), a primary throttling element (150), and an evaporator (130) sequentially connected through a pipeline and forming a closed loop; and
an electronic device cooling branch connected into the refrigeration loop from the condenser, and connected back to the refrigeration loop from the evaporator; the electronic device cooling branch including an electronic device cooling unit (160), a secondary throttling element (200), and an electromagnetic valve (140);
the refrigeration system being **characterized in that** the electronic device cooling unit, the secondary throttling element and the electromagnet valve are each arranged within the housing, the electronic device cooling unit being spaced apart from the electronic device, and being for reducing the temperature and humidity of the electronic device and an environment in the housing.

2. The refrigeration system according to claim 1, wherein the electronic device cooling unit includes an air-refrigerant heat exchanger (161) and a fan (162) that provides forced air convection, wherein the air-refrigerant heat exchanger is connected in parallel to the primary throttling element.

3. The refrigeration system according to claim 2, further including a condensed water collecting unit arranged below the air-refrigerant heat exchanger in the housing.

4. The refrigeration system according to claim 3, wherein the condensed water collecting unit is a water pan (170).

5. The refrigeration system according to claim 3 or 4, further including a condensed water discharging unit (180) for discharging condensed water out of the housing, the condensed water discharging unit being arranged outside the housing and in fluidic communication with the condensed water collecting unit.

6. The refrigeration system according to any preceding claim, wherein the electromagnetic valve and the secondary throttling element are arranged in the housing.

7. The refrigeration system according to any preceding claim, wherein the primary throttling element is a ball float valve.

8. The refrigeration system according to claim 2, further including a temperature sensor and/or a humidity sensor, the temperature sensor and/or the humidity sensor being arranged in the housing, and the refrigeration system being used for controlling opening or start and stop of the electromagnetic valve and the fan according to a parameter detected by the temperature sensor and/or the humidity sensor.

9. The refrigeration system according to any preceding claim, wherein the compressor is a centrifugal compressor.

10. A cooling method for an electronic control unit (190) of the refrigeration system (100) according to any preceding claim, including:
switching on the electromagnetic valve (140) and a fan (162) in the electronic device cooling unit (190) when it is detected that an ambient temperature in the housing (192) of the electronic control unit is higher than a preset temperature; and/or
switching on the electromagnetic valve and the fan in the electronic device cooling unit when it is detected that a dew point temperature corresponding to the ambient humidity in the housing of the electronic control unit is less than the ambient temperature in the housing of the electronic control unit; and/or
sending an alarm signal and/or switching off the electromagnetic valve, the fan in the electronic device cooling unit, and the compressor in the refrigeration loop when it is detected that the dew point temperature corresponding to the ambient humidity in the housing of the electronic control unit is higher than or equal to the ambient temperature in the housing of the electronic control unit.

## Patentansprüche

1. Kühlsystem (100), beinhaltend:
eine elektronische Steuereinheit (190), welche ein Gehäuse (192) und eine in dem Gehäuse angeordnete elektronische Vorrichtung (191) beinhaltet;
einen Kühlkreislauf, welcher einen Kompressor (110), einen Kondensator (120), ein primäres Drosselelement (150) und einen Verdampfer (130) beinhaltet, welche durch eine Rohrleitung hintereinander geschaltet sind und einen geschlossenen Kreislauf bilden; und
einen Kühlstrang der elektronischen Vorrichtung, welcher von dem Kondensator in den Kühlkreislauf geschaltet und von dem Verdampfer zurück in den Kühlkreislauf geschaltet wird; wobei der Kühlstrang der elektronischen Vorrichtung eine Kühleinheit (160) der elektronischen Vorrichtung, ein zweites Drosselelement (200) und ein elektromagnetisches Ventil (140) beinhaltet;
wobei das Kühlsystem **dadurch gekennzeichnet ist, dass**
die Kühleinheit der elektronischen Vorrichtung, das sekundäre Drosselelement und das Elektromagnetventil jeweils innerhalb des Gehäuses angeordnet sind, wobei die Kühleinheit der elektronischen Vorrichtung von der elektronischen Vorrichtung beabstandet ist, und zur Reduzierung der Temperatur und Feuchtigkeit der elektronischen Vorrichtung und einer Umgebung in dem Gehäuse dient.

2. Kühlsystem nach Anspruch 1, wobei die Kühleinheit der elektronischen Vorrichtung einen Luft-Kältemittel-Wärmetauscher (161) und ein Gebläse (162) beinhaltet, welches erzwungene Luftkonvektion bereitstellt, wobei der Luft-Kältemittel-Wärmetauscher zu dem primären Drosselelement parallel geschaltet ist.

3. Kühlsystem nach Anspruch 2, welches weiter eine Kondenswassersammeleinheit beinhaltet welche unter dem Luft-Kältemittel-Wärmetauscher in dem Gehäuse angeordnet ist.

4. Kühlsystem nach Anspruch 3, wobei die Kondenswassersammeleinheit eine Wasserschale (170) ist.

5. Kühlsystem nach Anspruch 3 oder 4, welches weiter eine Kondenswasserabgabeeinheit (180) zum Abgeben von Kondenswasser aus dem Gehäuse beinhaltet, wobei die Kondenswasserabgabeeinheit außerhalb des Gehäuses angeordnet ist und in Fluidverbindung mit der Kondenswassersammeleinheit steht.

6. Kühlsystem nach einem der vorstehenden Ansprüche, wobei das elektromagnetische Ventil und das zweite Drosselelement in dem Gehäuse angeordnet sind.

7. Kühlsystem nach einem der vorstehenden Ansprüche, wobei das primäre Drosselelement ein Schwimmerventil ist.

8. Kühlsystem nach Anspruch 2, welches weiter einen Temperatursensor und/oder einen Feuchtigkeitssensor beinhaltet, wobei der Temperatursensor und/oder der Feuchtigkeitssensor in dem Gehäuse angeordnet sind, und wobei das Kühlsystem zum Steuern von Öffnen bzw. Start und Stopp des elektromagnetischen Ventils und des Gebläses gemäß einem von dem Temperatursensor und/oder dem Feuchtigkeitssensor erkannten Parameter verwendet wird.

9. Kühlsystem nach einem der vorstehenden Ansprüche, wobei der Kompressor ein Zentrifugalkompressor ist.

10. Kühlverfahren für eine elektronische Steuereinheit (190) des Kühlsystems (100) nach einem der vorstehenden Ansprüche, beinhaltend:
Einschalten des elektromagnetischen Ventils (140) und eines Gebläses (162) in der Kühleinheit der elektronischen Vorrichtung (190), wenn erkannt wird, dass eine Umgebungstemperatur in dem Gehäuse (192) der elektronischen Steuereinheit höher als eine voreingestellte Temperatur ist; und/oder
Einschalten des elektromagnetischen Ventils und des Gebläses in der Kühleinheit der elektronischen Vorrichtung, wenn erkannt wird, dass eine Taupunkttemperatur, welche der Umgebungsfeuchtigkeit in dem Gehäuse der elektronischen Steuereinheit entspricht, niedriger als die Umgebungstemperatur in dem Gehäuse der elektronischen Steuereinheit ist; und/oder
Senden eines Warnsignals und/oder Ausschalten des elektromagnetischen Ventils, des Gebläses in der Kühleinheit der elektronischen Vorrichtung und des Kompressors in dem Kühlkreislauf, wenn erkannt wird, dass die Taupunkttemperatur, welche der Umgebungsfeuchtigkeit in dem Gehäuse der elektronischen Steuereinheit entspricht, höher als die oder gleich der Umgebungstemperatur in dem Gehäuse der elektronischen Steuereinheit ist.

## Revendications

1. Système de réfrigération (100), incluant :
un bloc de commande électronique (190), incluant un boîtier (192) et un dispositif électronique (191) agencé dans le boîtier ;
une boucle de réfrigération, incluant un compresseur (110), un condenseur (120), un organe d'étranglement primaire (150) et un évaporateur (130) reliés de manière séquentielle par l'intermédiaire d'une conduite et formant une boucle fermée ; et
une branche de refroidissement de dispositif électronique reliée dans la boucle de réfrigération à partir du condenseur, et reliée à nouveau à la boucle de réfrigération à partir de l'évaporateur ; la branche de refroidissement de dispositif électronique incluant une unité de refroidissement de dispositif électronique (160), un organe d'étranglement secondaire (200), et un robinet électromagnétique (140) ;
le système de réfrigération étant **caractérisé en ce que**
l'unité de refroidissement de dispositif électronique, l'organe d'étranglement secondaire et
le robinet électromagnétique sont chacun agencés dans le boîtier, l'unité de refroidissement de dispositif électronique étant espacée du dispositif électronique, et servant à réduire la température et l'humidité du dispositif électronique et d'un environnement dans le boîtier.

2. Système de réfrigération selon la revendication 1, dans lequel l'unité de refroidissement de dispositif électronique inclut un échangeur de chaleur air-réfrigérant (161) et un ventilateur (162) qui fournit une convection d'air forcée, dans lequel l'échangeur de chaleur air-réfrigérant est relié en parallèle à l'organe d'étranglement primaire.

3. Système de réfrigération selon la revendication 2, incluant en outre une unité de collecte d'eau condensée agencée en dessous de l'échangeur de chaleur air-réfrigérant dans le boîtier.

4. Système de réfrigération selon la revendication 3, dans lequel l'unité de collecte d'eau condensée est un bac à eau (170).

5. Système de réfrigération selon la revendication 3 ou 4, incluant en outre une unité d'évacuation d'eau condensée (180) permettant d'évacuer de l'eau condensée hors du boîtier, l'unité d'évacuation d'eau condensée étant agencée à l'extérieur du boîtier et en communication fluidique avec l'unité de collecte d'eau condensée.

6. Système de réfrigération selon une quelconque revendication précédente, dans lequel le robinet électromagnétique et l'organe d'étranglement secondaire sont agencés dans le boîtier.

7. Système de réfrigération selon une quelconque revendication précédente, dans lequel l'organe d'étranglement primaire est un robinet à flotteur.

8. Système de réfrigération selon la revendication 2, incluant en outre un capteur de température et/ou un capteur d'humidité, le capteur de température et/ou le capteur d'humidité étant agencés dans le boîtier, et le système de réfrigération servant à commander une ouverture ou une mise en marche et un arrêt du robinet électromagnétique et du ventilateur selon un paramètre détecté par le capteur de température et/ou le capteur d'humidité.

9. Système de réfrigération selon une quelconque revendication précédente, dans lequel le compresseur est un compresseur centrifuge.

10. Procédé de refroidissement pour un bloc de commande électronique (190) du système de réfrigération (100) selon une quelconque revendication précédente, incluant :
un allumage du robinet électromagnétique (140) et d'un ventilateur (162) dans l'unité de refroidissement de dispositif électronique (190) lorsqu'il est détecté qu'une température ambiante dans le boîtier (192) du bloc de commande électronique est supérieure à une température prédéfinie ; et/ou
un allumage du robinet électromagnétique et du ventilateur dans l'unité de refroidissement de dispositif électronique lorsqu'il est détecté qu'une température du point de rosée correspondant à l'humidité ambiante dans le boîtier du bloc de commande électronique est inférieure à la température ambiante dans le boîtier du bloc de commande électronique ; et/ou
un envoi d'un signal d'alarme et/ou une extinction du robinet électromagnétique, du ventilateur dans l'unité de refroidissement de dispositif électronique, et du compresseur dans la boucle de réfrigération lorsqu'il est détecté que la température du point de rosée correspondant à l'humidité ambiante dans le boîtier du bloc de commande électronique est supérieure ou égale à la température ambiante dans le boîtier du bloc de commande électronique.
